(19) Europäisches Patentamt
European Patent Office
Office européen des brevets

(11) **EP 4 118 587 B1**

(12) # EUROPEAN PATENT SPECIFICATION

(45) Date of publication and mention
of the grant of the patent:
**02.07.2025 Bulletin 2025/27**

(21) Application number: **21709991.0**

(22) Date of filing: **08.03.2021**

(51) International Patent Classification (IPC):
**G06N 10/40** (2022.01)   **B82Y 10/00** (2011.01)
**H10D 48/00** (2025.01)   **H10D 64/27** (2025.01)

(52) Cooperative Patent Classification (CPC):
**G06N 10/40; H10D 48/3835; H10D 64/27;**
B82Y 10/00

(86) International application number:
**PCT/EP2021/055819**

(87) International publication number:
**WO 2021/180668 (16.09.2021 Gazette 2021/37)**

(54) **A QUBIT PROCESSING METHOD**

VERFAHREN ZUR QUBIT-VERARBEITUNG

PROCÉDÉ DE TRAITEMENT DE BITS QUANTIQUES

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **13.03.2020 EP 20162973**

(43) Date of publication of application:
**18.01.2023 Bulletin 2023/03**

(73) Proprietor: **Quantum Motion Technologies
Limited
London N7 9HJ (GB)**

(72) Inventors:
• **PATOMAKI, Sofia
Yorkshire HG1 2PW (GB)**
• **MORTON, John
Yorkshire HG1 2PW (GB)**

• **BENJAMIN, Simon
Yorkshire HG1 2PW (GB)**

(74) Representative: **Gill Jennings & Every LLP
The Broadgate Tower
20 Primrose Street
London EC2A 2ES (GB)**

(56) References cited:
**US-A1- 2019 042 965**

• **LI R ET AL: "A Crossbar Network for Silicon
Quantum Dot Qubits", ARXIV.ORG, CORNELL
UNIVERSITY LIBRARY, 201 OLIN LIBRARY
CORNELL UNIVERSITY ITHACA, NY 14853, 10
November 2017 (2017-11-10), XP081404235, DOI:
10.1126/SCIADV.AAR3960**

## Description

### FIELD OF THE INVENTION

The present invention relates to a qubit processing method and a qubit processor for performing the method.

### BACKGROUND TO THE INVENTION

Quantum computation involves the manipulation and processing of qubits. A qubit, or a quantum bit, is the quantum parallel to the classical "bit" used in classical computing, and contains information. There are a number of possible quantum computing schemes that can be used to process qubits.

One quantum computing scheme involves manipulating the qubits using a sequence of quantum logic gates. In one such gate-based approach, pulsed, local and global electromagnetic waves and electrostatic potentials sequentially manipulate the states of stationary qubits and qubit pairs arranged on a lattice. The manipulation of the qubit states is controlled by controlling the parameters of the electromagnetic waves and potentials to implement a series of quantum logic gates across the lattice. The configuration of the gates is changed over time. Typically, a final stage in the process is the readout of the qubit states, most commonly reading all qubits in the lattice.

In the near-term intermediate-scale quantum computing, or NISQ, era, the number and density of qubits on each device is increasing. It is possible, for example using silicon metal-oxide-semiconductor, Si-MOS, devices, to create dense two dimensional grids of electron spin qubits which can physically accommodate this growth. Li R. et. al., 10 November 2017: "A Crossbar Network for Silicon Quantum Dot Qubits", disclose a quantum processor based on a 2d array of quantum dots, wherein the quantum dots may be shuttled and one- or two-qubit operations may be performed, and wherein operations may also be performed in parallel. Clarke J. et. al, 7 February 2019, US 2019/042965 A1, disclose a method for dynamically configuring a quantum bit lattice based on a quantum algorithm to be executed, wherein the lattice is sparse so that physical qubits can be shuttle through it in order to perform two-qubit operations as required by the quantum algorithm.

However, performing a series of quantum logic gates on a device (e.g. to run a quantum algorithm) requires delivering a sequence of simultaneous and complex fast pulses onto the device, the difficulty of which is only increased when the number of qubits is increased. The processing of large numbers of qubits in this way is resource intensive and is an engineering challenge. As such, it is difficult to envisage scaling up of such devices.

It is desirable to create a processor and processing method suitable for use in the NISQ era.

### SUMMARY OF THE INVENTION

A first aspect of the invention provides a method for performing quantum computations as defined in claim 1.

Advantageously, the processing of qubits in this way reduces the resources required to perform a qubit processing method. Each set of locations is configured in a compilation stage to perform a particular one- or two-qubit operation. During a run stage, the configuration of each set of locations remains fixed while the first and second qubits can be physically transferred from one set of locations to another to perform a series of processing steps. In this way, each qubit group is processed in the same way. That is, each qubit received at a particular location in a set of locations undergoes the same operation. The first and second locations in the first set of locations are configured to perform first and second one-qubit operations respectively. Accordingly, the first qubit of each qubit group will be manipulated according to the pre-defined first one-qubit operation. Similarly, the second one-qubit operation will be performed on the state of the second qubit of each qubit group. The first and second locations in the second set of locations are configured to enable a two-qubit interaction and thus each first and second qubit in each qubit group processed using this method will undergo the two-qubit interaction in the second set of locations according to the configuration.

At a given location or set of locations, only one type of operation is performed until the device is reset in a subsequent compilation stage. For example, a set of locations may be configured to perform a Z rotation at each location, and the amount of rotation may be tunable for each location within the set of locations. Preferably, the locations are tuned to desired parameters in the compilation stage and remain constant during the run stage.

The first qubit and the second qubit are provided within a first qubit group comprising n qubits, where n is greater than 2. In the NISQ era, qubit processors are capable of processing a large number of qubits. The number of qubits in a first qubit group is preferably greater than 50, and more preferably greater than 100, so that the qubit processing method can perform a simulation that is not able to be classically simulated. Typically, the number of locations in each set of locations will be the same as or greater than the number of qubits in the first qubit group. Each location preferably comprises an electrode which can be configured to perform an operation on a qubit. Optionally, the first qubit group can be supported in any set of locations and can be manipulated and transferred between sets of locations as a unit. This can simplify the process by using fast, global control between sets of locations to perform the transferring steps.

The qubit processing method comprises the steps of receiving a first qubit and a second qubit of a second qubit group at the first and second locations respectively in the first set of locations at time $t_2$. The first and second qubits of the first qubit group are received at the first and second locations respectively in the first set of locations at time $t_1$, and $t_2 > t_1$. An advantage of this method of processing qubits is the ability to process multiple groups of qubits in the qubit processor simultaneously, by starting to process a second qubit group in the processor shortly after the first qubit group. This can be achieved by transferring the first qubit group in space. The processing of multiple qubit groups simultaneously can increase the throughput. Preferably, during an operation stage in which an operation can be performed on a qubit, the first and second qubit groups are separated by at least two unoccupied sets of locations. Optionally, the first and second qubit groups are separated by one unoccupied set of locations.

The first and second qubits of the first qubit group may be transferred from the first and second locations respectively of the second set of locations to the first and second locations of the third set of locations at time $t_{tr}$, which is typically after the first qubit group is received at the first set of locations, i.e. $t_{tr} > t_1$. The third set of locations is an intermediate set of locations between the second set of locations and the readout set of locations. Preferably, the transfer of the first qubit group from the second set of locations to the third set of locations occurs before the second qubit group is received at the first set of locations, i.e. $t_{tr} \le t_2$. Advantageously, this provides an empty set of locations between the first qubit group and the second qubit group within the processor. The first qubit group and the second qubit group may be separated by a minimum of a single unoccupied set of locations. This distance can be maintained throughout, and avoids unintentional qubit interactions across the first and second qubit groups. Optionally, a plurality of groups of qubits are processed simultaneously and independently, occupying the same relative locations in different sets of locations.

Typically, there are N sets of locations in the qubit processor, wherein $N > 3$. The value of N may be determined by the desired number of steps in the computer program. There is preferably one step performed at each set of locations and therefore N sets of locations can accommodate N programming steps. Typically the state of the qubits is read out at the end of the computation. The N-th set of locations therefore preferably comprise the readout set of locations.

Optionally, the state of the first qubit of the first qubit group is read at time $t_r$; and the state of the second qubit of the first qubit group is read at time $t_r$; wherein $t_r > t_2$. In this example, the processing of the second qubit group, received at the first set of locations at time $t_2$, starts before the processing of the first qubit group is complete. Typically, a final step in the qubit processing method is the readout of the states of the qubits within the group. Advantageously, the processing of multiple qubit groups simultaneously by the qubit processor increases the processing capacity.

Each group of qubits are processed in the same way as the group traverses the qubit processor through successive sets of locations from the first set of locations to the readout set of locations. Accordingly, if no errors occur, the state of the i-th qubit in each of the qubit groups will be the same. Each qubit group typically comprises n qubits, $1 \le i < n$. Nevertheless, errors are expected to occur which will impact the state of one or more qubits. It is not currently possible to entirely eliminate errors, and thus typically quantum computations are performed multiple times to reduce the effect of errors on the computation. This method of processing qubits advantageously allows a plurality of qubit groups to be processed independently and simultaneously in the qubit processor to perform multiple repetitions of the same series of operations in quick succession to determine the average state of each qubit.

Preferably, each set of locations in the qubit processor may be configured to perform an operation on the states of qubits in a qubit group. An operation optionally comprises, or consists of, waiting. Each qubit group is typically received by successive sets of locations, terminating at the readout set of locations. Multiple qubits may be processed synchronously. Optionally, the qubit processing method further comprises the steps of: transferring the first qubit of the first qubit group from the first location in the third set of locations to a first location in a fourth set of locations at time $t_3$; transferring the second qubit of the first qubit group from the second location in the third set of locations to a second location in the fourth set of locations at time $t_3$; transferring the first qubit of the second qubit group from the first location in the first set of locations to the first location in the second set of locations at time $t_3$; and transferring the second qubit of the second qubit group from the second location in the first set of locations to the second location in the second set of locations at time $t_3$; wherein $t_3 > t_2$. Advantageously, the transfer of multiple qubit groups between sets of locations can be performed synchronously and globally. The fourth set of locations is an intermediate set of locations between the third set of locations and the readout set of locations.

Generally, a two-qubit interaction may be enabled in a set of locations in the qubit processing method. Preferably, an n-qubit processing method further comprises the step of enabling an interaction between an i-th qubit in the first qubit group and an (i+1)-th qubit in the first qubit group such that each qubit in the first qubit group directly or indirectly interacts with every other qubit in the first qubit group. For a first qubit group comprising n qubits, $1 \le i < n$. The position at which an interaction between a particular pair of qubits occurs may be dependent on the configuration of the sets of locations and the locations within the sets of locations. The i-th and (i+1)-th qubits are preferably physically adjacent qubits in the group, and enabling an interaction may comprise bringing the qubits closer together spatially to increase the tunnel coupling between the qubits such that a nearest neighbour interaction is enabled, such as nearest neighbour Heisenberg exchange.

The qubit processing method comprises the step of enabling an interaction between two qubits. More generally, in an n-qubit group, an interaction may be enabled between any adjacent pair of qubits within the n-qubit group. However, the temporal, and spatial, separation between consecutive qubit groups preferably ensures that there will be no inter-group qubit interactions. For example, the first qubit in the first qubit group and the first qubit in the second qubit group do not interact. Preferably, during an operation stage, the first and second qubit groups are separated by at least one unoccupied set of locations in order to avoid interactions between qubits belonging to different qubit groups. If the time taken to perform the manipulation and transfer steps are unequal between sets of locations, it may be necessary to have two or more unoccupied sets of locations between each occupied set of locations.

An unoccupied set of locations may be initialised. Optionally, any or all of the unoccupied sets of locations may be globally reset to "zero". The qubit processing method may further comprise performing an initialisation operation on the first set of locations. The performing of an initialisation operation may occur after the transfer of the first and second qubits of the first qubit group from the first and second locations of the first set of locations respectively, and before the receipt of the first and second qubits of the second qubit group at the first and second locations of the first set of locations respectively. This can advantageously prevent unwanted crosstalk in the event of an imperfect transfer of qubits. Optionally, the qubit state can be measured following the transfer of the first and second qubits of the first qubit group from the first and second locations of the first set of locations and before performing the initialisation operation. In this case, the measurement will be zero unless an error has occurred. Accordingly, this can advantageously be used to monitor the occurrence of errors and perform a global reset in the event of an error.

Optionally, the qubits are electron spin qubits or trapped ion qubits or superconducting qubits. Electron spin qubits are suitable for quantum computational processes as they can be easily manipulated and coupled to other electron spin qubits. Trapped ion qubits beneficially provide stability which can improve the fault tolerance of the quantum computation. Superconducting qubits may provide long coherence times. Preferably the qubits are electron spin qubits in silicon-based devices, as these advantageously provide long coherence times and are compatible with existing technologies.

The steps of transferring qubits between sets of locations typically depends on the type of qubit chosen. For example, the transferring steps may comprise electron shuttling, wherein electron spin qubits or trapped ion qubits may be "shuttled". This refers to a process in which the local electric potential energy is modified to transport charge. An electron will settle into a local minimum in the electric potential energy landscape, and can be shuttled forwards by raising the electric potential energy in its current location and lowering the electric potential energy in the intended location, whilst maintaining high potential barriers elsewhere to guide the electron. This process is advantageous as it is reliable and tolerant to faults. Additionally, transferring using electron shuttling allows for global control of the movement of multiple qubit groups through the processor.

Alternatively, the transferring steps may comprise SWAP operations. In a SWAP operation, two qubits are swapped. Optionally, SWAP operations may be used to transfer superconducting qubits. In this example, there may be qubits at each location in each set of locations, which may beneficially increase the throughput.

This specification also describes a qubit processor. The qubit processor is capable of implementing the qubit processing method according to the first aspect of the invention. Any features of the qubit processing method may be implemented in the qubit processor, and any features of the qubit processor may be used to perform the qubit processing method. Each aspect of the invention shares similar advantages. The qubit processor comprises: a first set of locations; a second set of locations; and a readout set of locations. Each set of locations comprises at least a first location and a second location configured to receive a first qubit and a second qubit respectively. The first location in the first set of locations is configured to perform a first one-qubit operation and the second location in the first set of locations is configured to perform a second one-qubit operation. The first set of locations is configured to: receive a first qubit at the first location and a second qubit at the second location; perform the first one-qubit operation on the state of the first qubit; and perform the second one-qubit operation on the state of the second qubit. The first and second locations in the second set of locations are configured to enable a two-qubit interaction. The first qubit and the second qubit are transferred from the first set of locations to the second set of locations. The second set of locations is configured to enable the two-qubit interaction between the first qubit and the second qubit. The first qubit and the second qubit are transferred from the second set of locations to the readout set of locations. The readout set of locations are configured to read the state of the first qubit and the state of the second qubit.

The qubit processor is preferably fabricated using SiMOS technology, in which high density qubit arrangements are possible with low power requirements. The qubit processor is preferably configured to process groups of n qubits, and typically each set of locations is configured to have at least n locations to accommodate the n-qubit group. Each of the n locations may comprise an electrode. Optionally, a voltage may be applied to one or more electrodes to effect one- or two-qubit operations. The number of processing steps depends on the implemented program. Typically the number of steps N is greater than 3, and the qubit processor typically comprises at least N set of locations.

Use of SiMOS technology to fabricate the qubit processor can provide a scalable architecture which may enable densely packed arrangements of qubits on a processing chip. The n-qubit processing method described may require an arrangement of N x n electrodes and preferably an N x n arrangement of corresponding locations. This is an alternative to a √n x √n arrangement on which N different processes can be performed sequentially. In the N x n arrangement of locations, the N sets of locations preferably correspond to N time steps, and then n locations within each set of locations preferably corresponds to the number of qubits in a group. A greater number of locations is possible using SiMOS technology, and the qubit processing method advantageously requires less input from signal generators. The control of the qubit groups during the qubit processing is advantageously simplified.

The qubit processor optionally comprises a third set of locations; wherein a voltage source is electrically connected to the first set of locations and the third set of locations so as to apply a voltage to the first set of locations and the third set of locations simultaneously. The third set of locations are preferably an intermediate set of locations between the second set of locations and the readout set of locations. An advantage of the qubit processing method described is the ability to process multiple groups of qubits within the processor at any one time. The transfer of qubits along the processor from one set of locations to the next set of locations may advantageously be performed globally. For example, the same voltage source may be used to transfer both the first qubit group and the second qubit group to the next set of locations, even though the first and second qubit groups may be spatially separated within the processor. Preferably there are at least two unoccupied sets of locations separating each occupied set of locations. Advantageously, the voltage source may be electrically connected to each occupied set of locations to control the movement of multiple qubit groups through the qubit processor.

The qubit processor may be set up in advance of running a qubit processing method as part of a quantum computation. This typically involves locally tuning the electrodes at each location such that each location in each set of locations can be configured to perform a certain manipulation or operation. An electrode at a location may be configured to perform a single qubit operation, or electrodes at a pair of adjacent locations in a set of locations may be configured to enable an interaction between two qubits. The qubit processor is preferably configured prior to performing the computation. During a computation stage, the qubit processor configuration preferably remains fixed such that each set of locations, and each location within the set of locations, performs the same operation on each consecutive group of qubits received.

Preferably, the qubit processing method comprises the compilation stage, a run-time stage, and a readout stage. During the compilation stage, the first and second locations in the first set of locations are configured to perform first and second one-qubit operations respectively. In an example, the first one-qubit operation is an X rotation and the second one-qubit operation is a Z rotation. In another example, the first and second one-qubit operations are the same type of operation. The first and second locations in the second set of locations are also configured during the compilation stage to enable a two-qubit interaction such as an exchange interaction.

Optionally, at the compilation stage, the voltages applied to electrodes at locations in sets of locations within the qubit processor can be tuned. The tuning optionally controls the qubit logic gate rates at individual locations within sets of locations; and tunnel rates of electrons between sets of locations. On specific sets of locations, voltage tuning may control qubit-qubit coupling strengths at individual locations within the sets of locations. During the run-time stage, the steps of receiving qubits, performing operations, transferring qubits and enabling interactions may be performed. The operations are performed according to the configuration of each location within each set of locations as set during the compilation stage. The tuning set up in the compilation stage may provide control of the qubits and the quantum information carried by the qubits during the run-time stage.

Optionally, the run-time stage comprises the steps of: synchronously receiving n qubit states at a k-th set of locations in a two-dimensional grid of locations; performing a synchronized manipulation, which can consist of waiting, on the states of the qubits at the k-th set of locations; and synchronously transferring n qubit states from the k-th set of locations onto the subsequent (k+1)-th set of locations.

Typically, alternate sets of locations are decoupled from each other, such that the manipulation realises a set of one-qubit logic gates. On the intermediate sets of locations, certain neighbouring qubits may be coupled to each other, such that manipulation realises two-qubit logic gates.

Preferably, having completed the above run-time steps for all sets of locations, the states of n qubits are read out at the final set of locations, the readout set of locations, during the readout stage.

This specification also describes a method for performing quantum computations in a qubit processor. The method comprises the steps of: receiving a first qubit at a first location in a first set of locations; receiving a second qubit at a second location in the first set of locations; performing an operation on the state of the first qubit at the first location in the first set of locations; performing an operation on the state of the second qubit at the second location in the first set of locations; transferring the first qubit from the first location in the first set of locations to a first location in a second set of locations;

transferring the second qubit from the second location in the first set of locations to a second location in the second set of locations; enabling interaction between the first qubit and the second qubit in the second set of locations; transferring the first qubit from the first location in the second set of locations to a first location in a readout set of locations; transferring the second qubit from the second location in the second set of locations to a second location in the readout set of locations; reading the state of the first qubit at the first location in the readout set of locations; and reading the state of the second qubit at the second location in the readout set of locations.

This specification also describes a qubit processor. The qubit processor is capable of implementing the qubit processing method according to the first aspect of the invention. Any features of the qubit processing method may be implemented in the qubit processor, and any features of the qubit processor may be used to perform the qubit processing method. Each aspect of the invention shares similar advantages. The qubit processor comprises: a first set of locations; a second set of locations; and a readout set of locations. Each set of locations comprises at least a first location and a second location. The first set of locations is configured to: receive a first qubit at the first location and a second qubit at the second location; and perform an operation on the state of the first qubit and the state of the second qubit. The first qubit and the second qubit are transferred from the first set of locations to the second set of locations. The second set of locations is configured to enable an interaction between the first qubit and the second qubit. The first qubit and the second qubit are transferred from the second set of locations to the readout set of locations. The readout set of locations are configured to read the state of the first qubit and the state of the second qubit.

## BRIEF DESCRIPTION OF THE DRAWINGS

Embodiments of the invention will now be described with reference to the accompanying drawings in which:

> Figure 1 is a schematic illustration of a qubit processor in accordance with a first embodiment;
> Figure 2 is a schematic illustration of a qubit processor in accordance with a second embodiment;
> Figure 3 is a schematic illustration of a qubit processor in accordance with a third embodiment;
> Figure 4A is a schematic illustration of a qubit processor in accordance with a fourth embodiment at time $t_a$;
> Figure 4B is a schematic illustration of a qubit processor in accordance with the fourth embodiment at time $t_b > t_a$;
> Figure 5 is a schematic illustration of a qubit processor in accordance with a fifth embodiment;
> Figure 6A is a schematic illustration of a qubit processor in accordance with a sixth embodiment at time $t_1$;
> Figure 6B is a schematic illustration of a qubit processor in accordance with the sixth embodiment at time $t_2$;
> Figure 6C is a schematic illustration of a qubit processor in accordance with the sixth embodiment at time $t_3$;
> Figure 6D is a schematic illustration of a qubit processor in accordance with the sixth embodiment at time $t_4$;
> Figure 7 is a schematic illustration of an operation in a qubit processor in accordance with a seventh embodiment;
> Figure 8A is a first schematic illustration of an operation in a qubit processor in accordance with an eighth embodiment;
> Figure 8B is a second schematic illustration of an operation in a qubit processor in accordance with the eighth embodiment;
> Figure 9 is a flow chart of an operation in a qubit processor in accordance with a ninth embodiment;
> Figure 10A is a first schematic illustration of an operation in a qubit processor in accordance with a tenth embodiment;
> Figure 10B is a second schematic illustration of an operation in a qubit processor in accordance with the tenth embodiment;
> Figure 10C is a third schematic illustration of an operation in a qubit processor in accordance with the tenth embodiment;
> Figure 11 is a flow chart of an operation in a qubit processor in accordance with an eleventh embodiment;
> Figure 12 is a schematic illustration of a top view of a qubit processor in accordance with a twelfth embodiment;
> Figure 13A is a schematic illustration of a top view of a qubit processor in accordance with a thirteenth embodiment; and
> Figure 13B is a schematic illustration of a cross-sectional view of a qubit processor in accordance with the thirteenth embodiment.

## DETAILED DESCRIPTION

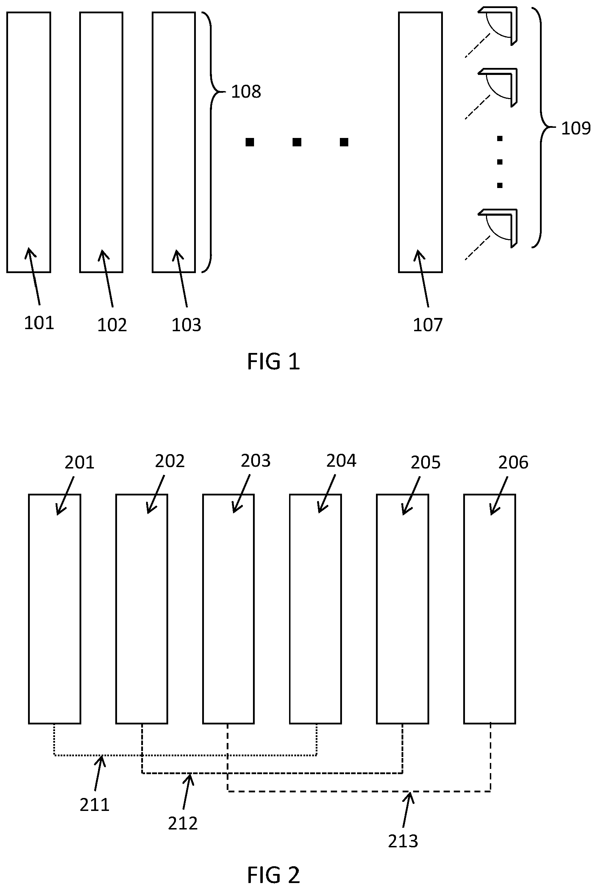

Figure 1 shows schematically first 101, second 102, third 103 and N-th 107 sets of locations in a first embodiment. Each set of locations 101-103, 107 is configured to support a group of qubits 108 and manipulate the states of the qubits within the group. In this embodiment, each set of locations 101-103, 107 is configured to perform a pre-determined operation on the qubits within the set of locations. In order to perform a series of operations on the qubits in the quantum computing scheme, the group of qubits is shuttled from one set of locations to the next set of locations. A qubit processing method comprising N steps can be implemented in this embodiment by including N sets of locations. The n-th step is performed at the n-th set of locations, wherein $1 \leq n \leq N$. The N-th set of locations 107 is a readout set of locations, at which the state of each qubit within the group can be read out by readout apparatus 109.

Figure 2 shows schematically six neighbouring sets of locations 201, 202, 203, 204, 205, 206 in accordance with a second embodiment. In this embodiment, the time taken to perform an operation is the same for each set of locations 201-206. The qubit processing method proceeds by alternating operation steps and shuttling steps. During an operation step, the group of qubits is manipulated according to the pre-determined operation for that set of locations. During a shuttling step, the group of qubits is shuttled from the n-th set of locations to the (n+1)-th set of locations, wherein $1 \leq n \leq N-1$ and there are N sets of locations in total. This method of processing qubits advantageously allows multiple groups of qubits to be processed successively.

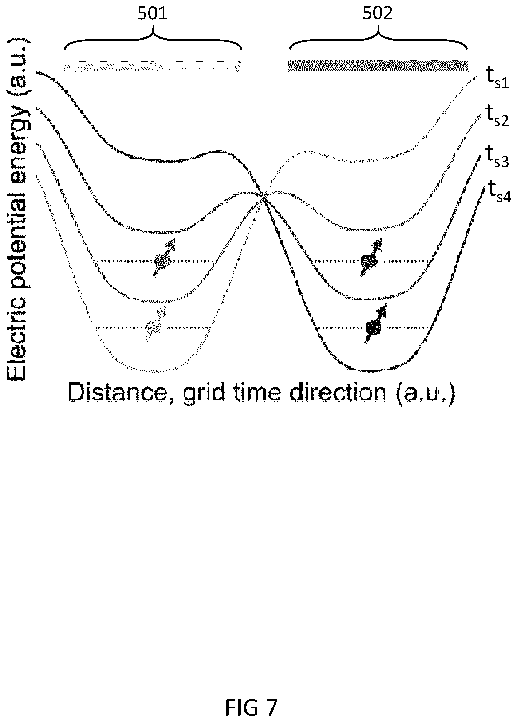

Figure 2 illustrates the electrical connections between the six sets of locations 201-206 shown. The first and fourth sets of locations 201, 204 are synchronously controlled by a first voltage source 211. Similarly, the second and fifth sets of locations 202, 205, and the third and sixth sets of locations 203, 206, are controlled synchronously by a second and a third voltage source 212, 213 respectively. Each of the voltage sources 211-213 is a fast pulse generator and is electrically connected to every third set of locations. The voltage applied by each of the voltage sources can be modified to shuttle the group of qubits from the n-th set of locations to the (n+1)-th set of locations, as will be described with reference to Figure 7. The joint control of every third set of locations with a single voltage source allows groups of qubits to populate every third set of locations and be shuttled simultaneously. For example, with reference to Figure 2, a first group of qubits in the first set of locations and a second group of qubits in the fourth set of locations can be manipulated in accordance with the pre-determined operation for the first and fourth set of locations respectively. Following the operation step, the first and second groups of qubits can be shuttled to the second and fifth set of locations respectively by controlling the voltage applied to the first and second voltage sources. Following the shuttling step, the first and second groups of qubits can be manipulated in accordance with the pre-determined operation for the second and fifth set of locations respectively.

In an alternative embodiment, the transfer of a qubit group from one set of locations to the subsequent set of locations is performed using SWAP operations. In this example, each location in each set of locations may be occupied. Qubits are manipulated according to the pre-configured arrangement within a particular locations, and then a SWAP operation is performed. During a SWAP operation, a qubit in the n-th set of locations which has undergone the n-th manipulation operation, can be swapped with a qubit in the (n+1)-th set of locations by coupling the n-th and (n+1)-th sets of locations, wherein 1

$\leq n \leq N-1$ and there are N sets of locations in total. In this way, groups of data qubits proceed through the processor from the first set of locations to the N-th set of locations where their state is readout, and ancillary qubits proceed in a reverse direction, enabling the SWAPs throughout the processor. SWAP operations may be used to transfer any type of qubits, but may in particular be advantageous in an implementation using superconducting qubits. Similarly to the shuttling requirements, first and second qubit groups should be separated by at least two sets of locations to avoid inter-group qubit interactions when adjacent sets of locations are coupled.

Qubit processing methods typically require many repetitions to build up a representative statistical outcome. The simultaneous processing of consecutive qubit groups within the qubit processor as described allows many repetitions to be performed.

If the operation and shuttling times for each set of locations is constant, a maximum of every second set of locations may be occupied and therefore each voltage source can be electrically connected to every second set of locations in order to perform the transferring step of a qubit group from one set of locations to the next set of locations. In another embodiment, the operation and shuttling times for each set of locations may not be constant. In this case, the N sets of locations can be divided into blocks, wherein the time taken to perform the operation and shuttling steps is the same for each block. If the operation and shuttling times are not constant for each set of locations, it may be required to have more than two unoccupied sets of locations in between each occupied set of locations. In this case, each set of locations in a block will be electrically connected to a different voltage source. Use of one voltage source to control multiple sets of locations simultaneously advantageously reduces the required number and complexity of control and interconnect resources in the qubit processing method.

In another embodiment, an operation at a particular set of locations may take significantly longer to perform, for example an order of magnitude or more, than operations at the other sets of locations. For example, an initialisation operation at the first set of locations, or the readout operation at the N-th set of locations, may take a long time to perform. In this example, the qubit processor may only be able to support a single qubit group. However, the resources required to transfer the group through the processor, and similarly the complexity of the processing, will still be reduced. If only one qubit group is processed by the qubit processor at a time, only three, rather than N, voltage sources may be used to perform the transfer steps.

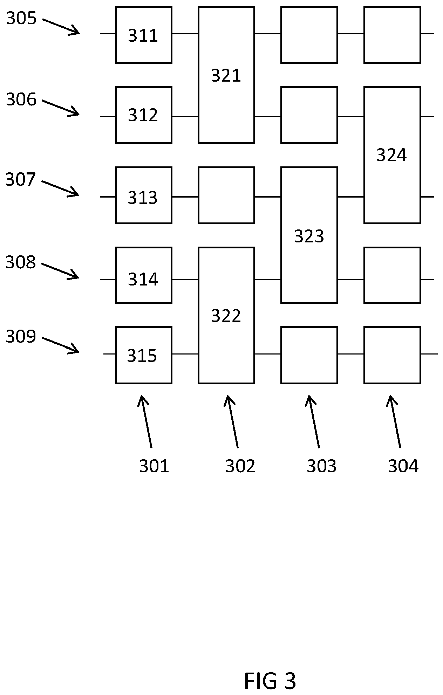

Figure 3 is an exemplary portion of a qubit processor circuit according to a third embodiment. Four sets of locations are shown 301, 302, 303, 304, with five electrodes 305, 306, 307, 308, 309 at respective locations in each set of locations 301-304. Each set of locations 301-304 may receive a group of n qubits, wherein each electrode 305-309 may receive a qubit. In this embodiment, there are five qubits in each qubit group, n = 5. In the first set of locations 301, there are five single-qubit quantum logic gates 311, 312, 313, 314, 315. In the second set of locations 302, the first and second electrodes, and the fourth and fifth electrodes, are coupled to form two-qubit quantum logic gates 321, 322. The second set of locations 302 is configured such that the first and second qubits from the first set of locations 301, having undergone a single-qubit operation in the first set of locations, interact with each other in the second set of locations 302. A similar interaction occurs between the fourth and fifth qubits in the second set of locations 302. The two-qubit quantum logic gates 323, 324, schematically illustrated in the third set of locations 303 and the fourth set of locations 304 respectively, ensure that each qubit interacts with the remaining qubits either directly or indirectly during the qubit processing method. This is generally achieved by enabling an interaction between adjacent qubits, i.e. the i-th qubit and the (i-1)-th and (i+1)-th qubits, for 1 < i < n. In alternative embodiments, the coupling of two electrodes to enable two-qubit interactions may occur in any of the sets of locations in the qubit processor.

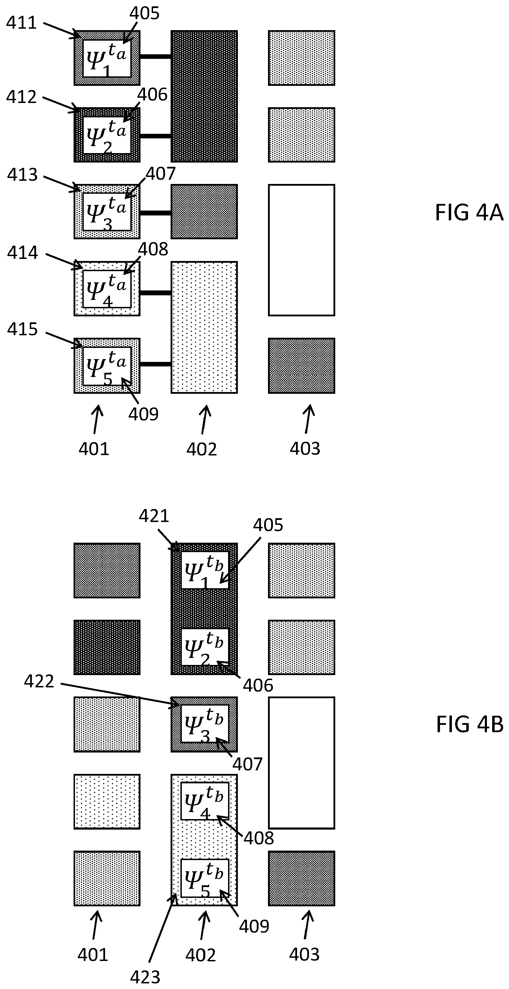

Figures 4A and 4B schematically illustrate a portion of a qubit processor circuit according to a fourth embodiment. In this example the qubits are electron spin qubits, in which electrons are confined in quantum dots and the quantum information is contained in the spin state of the electron. Three sets of locations 401, 402, 403 are shown. In Figure 4A, the group of n qubits 405, 406, 407, 408, 409 comprising five qubits, n = 5, has been manipulated in line with the control parameters pre-set for the first set of locations 401. In this embodiment, each electrode at a location in the first set of locations is configured as a single-qubit quantum logic gate 411, 412, 413, 414, 415. During the operation step in the first set of locations 401, each qubit 405-409 in the group of qubits therefore undergoes a single-qubit operation. At time $t_a$, after the operation step in the first set of locations 401 and before a shuttling step from the first set of locations 401 to the second set of locations 402, the state of each qubit 405-409 is represented as $\psi_i^{t_a}$, where $1 \leq i \leq 5$. Over a shuttling time $\Delta t_s$, the five qubits 405-409 are transferred to the second set of locations 402 as indicated by the horizontal lines.

In Figure 4B, the group of qubits 405-409 is in the second set of locations 402. The second set of locations comprises one one-qubit quantum logic gate 422 and two two-qubit quantum logic gates 421, 423. The group of qubits 405-409 is manipulated by the one- and two-qubit gates 421, 422, 423 during an operation time $\Delta t_g$. At time $t_b$, the state of each qubit 405-409 is represented as $\psi_i^{t_b}$, where $1 \leq i \leq 5$. The operation performed depends on the tuning of the control parameters, which are pre-set prior to running the qubit processing program.

The level of tuning is indicated schematically by the shading. For example, the angle of rotation can be tuned for a one-qubit quantum logic gate, or the strength of qubit-qubit interaction can be tuned for a two-qubit quantum logic gate. The control parameters remain fixed during the execution of a particular program, but can be retuned to perform a different program.

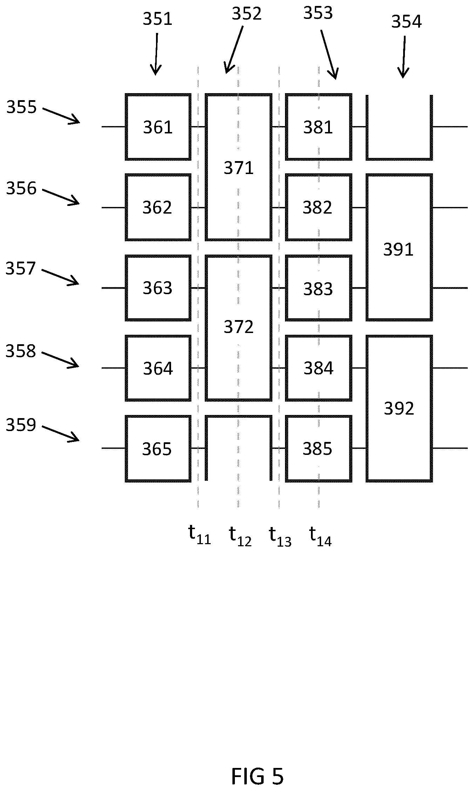

Figure 5 is an exemplary portion of a qubit processor circuit according to a fifth embodiment in which sets of locations alternate between decoupled and coupled configurations. Four sets of locations are shown 351, 352, 353, 354, with five electrodes 355, 356, 357, 358, 359 at respective locations in each set of locations 351-354. The first and third set of locations 351, 353 are in a decoupled configuration. In the first set of locations 351, there are five one-qubit quantum logic gates 361, 362, 363, 364, 365. The third set of locations 353 also has five one-qubit quantum logic gates 381, 382, 383, 384, 385. The intermediate sets of locations, i.e. the second and fourth sets of locations 352, 354, are in a coupled configuration in which the neighbouring qubits are coupled to each other to realise two-qubit logic gates. In the second set of locations 352, qubits at the first and second electrodes 355, 356, and qubits at the third and fourth electrodes 357, 358, are coupled to form two-qubit quantum logic gates 371, 372. In the fourth set of locations 354, the two-qubit quantum logic gates 391, 392 are configured to couple qubits at the second and third electrodes 356, 357, and at the fourth and fifth electrodes 358, 359 respectively. The two-qubit quantum logic gates 391, 392 in the fourth set of locations 354 are offset from the two-qubit quantum logic gates 371, 372 in the second set of locations 352. The arrangement of two-qubit gates effects direct or indirect interactions between qubits in the qubit processor. In alternative embodiments, any pair of adjacent electrodes may be coupled to realise a two-qubit gate.

In Figure 5, first to fourth times, $t_{11}$, $t_{12}$, $t_{13}$, $t_{14}$, indicate schematically the position of a qubit group in the processor at successive points in time. At time $t_{11}$, the qubit group is transferred from the first set of locations 351 to the second set of locations 352. At time $t_{12}$, an interaction is enabled between neighbouring qubits in the qubit group at the second set of locations 352. At time $t_{13}$, the qubit group is transferred from the second set of locations 352 to the third set of locations 353. At time $t_{14}$, each qubit in the qubit group undergoes a one-qubit operation at the third set of locations 353.

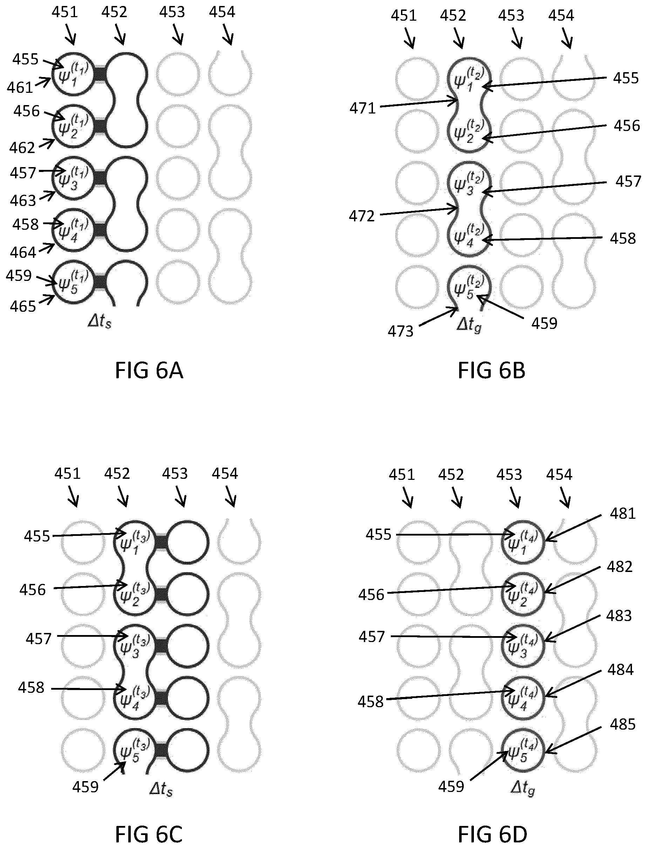

Figures 6A, 6B, 6C and 6D schematically illustrate a portion of a qubit processor circuit according to a sixth embodiment. Four sets of locations 451, 452, 453, 454 are shown, with alternating coupled and decoupled configurations. The positioning, in the qubit processor, of a qubit group comprising five qubits 455, 456, 457, 458, 459 is illustrated at different points in time during the run-time stage of the qubit processing method. The processing parameters of the qubit processor, i.e. the qubit precession frequency and nearest-neighbour-connectivity, are tuned at the compilation stage prior to the run-time stage. Selective tuning of the nearest-neighbour-connectivity forms the one- and two-qubit logic gates.

In Figure 6A, a first transferring step is depicted. The qubits are illustrated at time $t_1$, wherein the qubit states are represented as $\psi_i^{t_1}$, for $1 \leq i \leq 5$. The first set of locations 451 is configured in a decoupled arrangement, with five one-qubit quantum logic gates 461, 462, 463, 464, 465. Each qubit in the qubit group 455-459, having undergone a one-qubit operation at the one-qubit gates 461-465 of the first set of locations 451, is transferred over time $\Delta t_s$ to the second set of locations 452, as indicated by the horizontal lines.

In Figure 6B, the qubits 455-459 in the qubit group are in the second set of locations 452, which is configured in a coupled arrangement, at time $t_2 > t_1$. Over an operation time $\Delta t_g$, the group of qubits 455-459 is manipulated. An interaction is enabled between the first and second qubits 455, 456 at a first two-qubit quantum logic gate 471 and between the third and fourth qubits 457, 458 at a second two-qubit quantum logic gate 472. A portion of a two-qubit quantum logic gate 473 is shown at which the fifth qubit 459 interacts with an adjacent qubit (not shown). At time $t_2$, the qubit states are represented as $\psi_i^{t_2}$, for $1 \leq i \leq 5$.

Figure 6C illustrates a second transferring step, similar to that shown in Figure 6A. At time $t_3 > t_2$, the qubit states are represented as $\psi_i^{t_3}$, for $1 \leq i \leq 5$. The qubits 455-459 have undergone two-qubit operations in the second set of locations 452, as illustrated in Figure 6B. During time $\Delta t_s$, the qubit group 455-459 is transferred from the second set of locations 452 to the third set of locations 453.

In Figure 6D, the qubit group 455-459 is illustrated at the third set of locations 453 at time $t_4 > t_3$, wherein the qubit states are represented as $\psi_i^{t_4}$, for $1 \leq i \leq 5$. The third set of locations 453 is in a decoupled configuration. There are five one-qubit quantum logic gates 481, 482, 483, 484, 485 at the third set of locations 453. During an operation time $\Delta t_g$, each qubit 455-459 in the group of qubits undergoes a one-qubit operation.

Figure 7 schematically illustrates the shuttling of a qubit according to a seventh embodiment. The graph depicts the changing electric potential energy (in arbitrary units) over distance. The electric potential energy is across two trapping locations within two sets of locations 501, 502. In this embodiment, the electron potential landscape can be altered to "trap" electrons and transport electrons from one set of locations to another set of locations. The electric potential energy is illustrated at four points in time, $t_{s1}, t_{s2}, t_{s3}, t_{s4}$ during the shuttling time $\Delta t_s$, wherein $t_{s1} < t_{s2} < t_{s3} < t_{s4}$. At time $t_{s1}$, the electron is trapped in the first set of locations 501. Electrons are shuttled from the first set of locations 501 to the second set of locations 502 by inverting the biasing between sets of locations 501, 502. This results in a raising of the electric potential energy of the electrode at the trapping location in the first set of locations 501 and a lowering of the electric potential energy of the electrode at the trapping location in the second set of locations 502 during the shuttling step. Meanwhile, the electric potential energy of surrounding electrodes is maintained above a trapping threshold so as to confine the electron to a particular location within a set of locations. As the bias voltage is increased for the second set of locations 502 and decreased for the first set of locations 501, the electron moves with the electric potential and is shuttled from one set of locations to the next as the electron seeks out the low electric potential. The shifting bias locally creates a moving potential minimum for a single group of qubits. At time $t_{s4}$, the electron is trapped in the second set of locations 502.

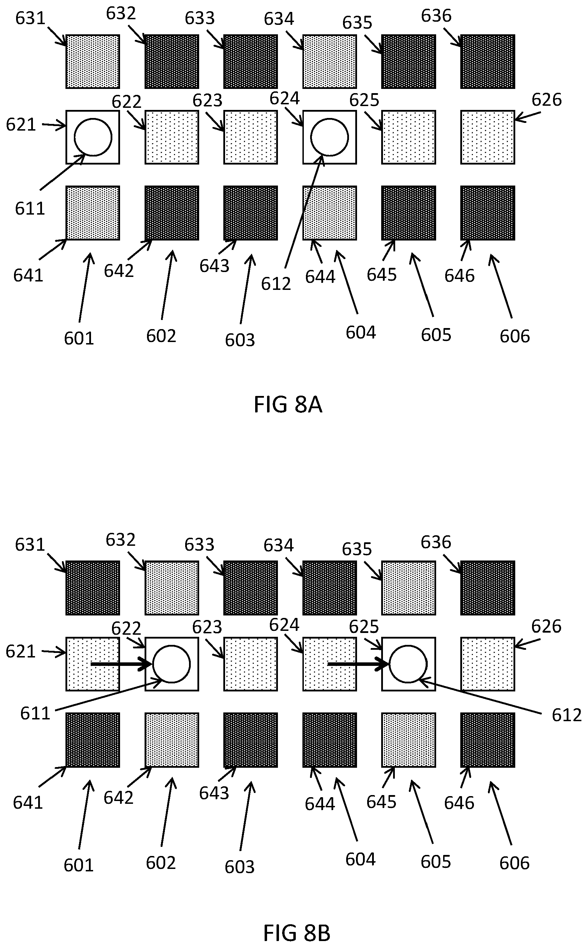

Figures 8A and 8B schematically illustrate a shuttling operation of one qubit. In each set of locations 601, 602, 603, 604, 605, 606, the processing time for the operation step is the same in this example. Therefore, each group of qubits can enter the qubit processor three sets of locations after the previous group of qubits. In this embodiment, six consecutive sets of locations 601-606 are shown. Each electrode at each location is schematically indicated by a square, and the electron potential of the electrode is indicated by the depth of the shading. A darker shade corresponds to a higher electric potential energy. The qubits 611, 612 are shown by circles on the electrodes. In this embodiment, each set of locations 601-606 comprises a "trapping" location comprising an electrode with a low electric potential energy. Each trapping location is surrounded by confining locations comprising electrodes with a high electric potential energy. In Figure 8A, the potential of the first and fourth sets of locations 601, 604 is offset such that the potential well of the electrodes at the respective trapping locations 621, 624 falls below a trapping threshold and the electrons 611, 612 are trapped.

In a shuttling process, the electric potential energy of the second and fifth sets of locations 602, 605 is lowered whilst the electric potential energy of the first and fourth sets of locations 601, 604 is raised. In this way, the electrons are transferred along the qubit processor in parallel. In Figure 8B, the electrons have been shuttled into the trapping locations 622, 625 within the second and fifth sets of locations 602, 605 respectively. The electric potential energy of the electrodes at the confining locations 631, 632, 633, 634, 635, 636, 641, 642, 643, 644, 645, 646 surrounding the trapping locations 621, 622, 623, 624, 625, 626 is too high to trap the electron, and thus these electrodes guide the electron to a chosen location within the set of locations.

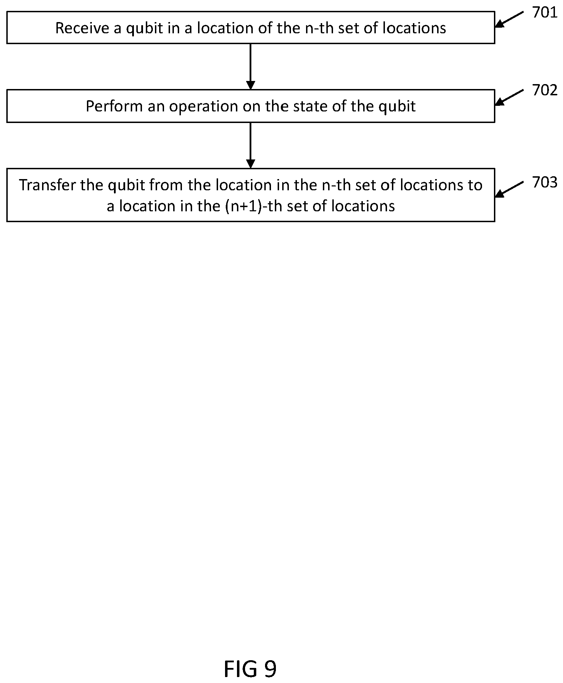

Figure 9 is a flow chart describing an operation involving a single qubit in a qubit processing method. A qubit is received 701 at a location of the n-th set of locations. This is achieved by applying an offset voltage to lower the potential well of the n-th set of locations to trap an electron at a trapping location. After the qubit is trapped, an operation is performed 702 on the state of the qubit. The operation may for example be an X or a Z rotation, and the parameters controlling this operation are pre-determined in a compilation stage of the qubit processor. After the qubit state has been manipulated, the qubit is transferred 703 from the location in the n-th set of locations to a corresponding location in the (n+1)-th set of locations.

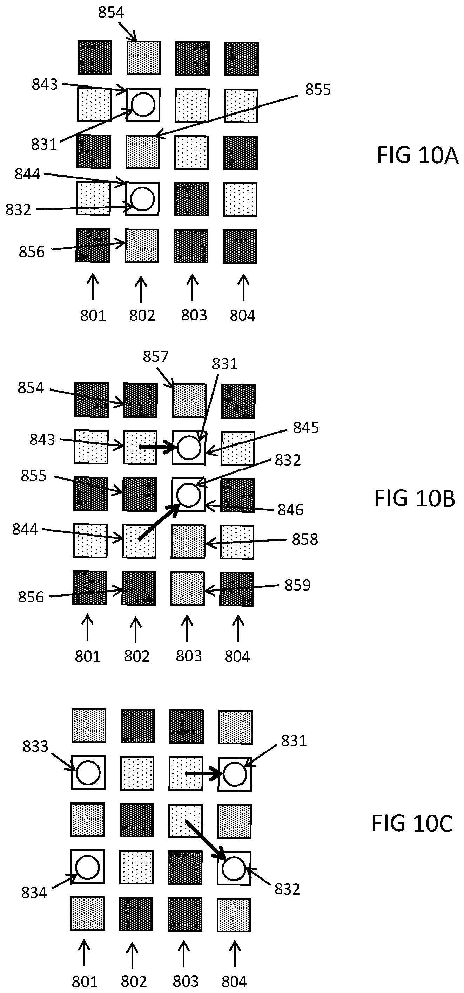

Figures 10A, 10B and 10C schematically illustrate a shuttling operation involving two qubits. In Figure 10A, the potential of the second set of locations 802 is offset so as to trap the group of n qubits in the second set of locations 802, where n = 2. In the second set of locations 802, the electrodes are configured such that two qubits 831, 832 are trapped in trapping locations 843, 844 and separated by confining locations 854, 855, 856. Each qubit 831, 832 undergoes a single qubit operation in the second set of locations 802, which takes time $\Delta t_{g2}$.

Figure 10B illustrates the movement of the electrons in a shuttling process from the second set of locations 802 to the third set of locations 803. The shuttling process takes time $\Delta t_{s2}$. In the third set of locations 803, the two qubits 831, 832 which were separated by a confining location 855 in the second set of locations 802 are brought together. This is achieved by configuring the electrodes of the confining locations 854-856 in the second set of locations 802 and the electrodes of the confining locations 857, 858, 859 in the third set of locations 803 such that the second qubit 832 is shuttled diagonally from the trapping location 844 in the second set of locations 802 to a trapping location 846 in the third set of locations 803. The first qubit 831 is shuttled horizontally from the trapping location 843 in the second set of locations 802 to a trapping location 845 in the third set of locations 803. In the third set of locations 803, the tunnel coupling between the first and second qubits 831, 832 is increased as they are in neighbouring locations. This enables a two-qubit interaction between the first and second qubits 831, 832 in the third set of locations 803. In this example, the two-qubit interaction takes place over time $\Delta t_{g3} = \Delta t_{g2}$.

In Figure 10C, the movement of the electrons in a second shuttling process taking time $\Delta t_{s3} = \Delta t_{s2}$ is shown, in which the first group of qubits is shuttled from the third set of locations 803 to the fourth set of locations 804. In the fourth set of locations 804, the second qubit 832 is shuttled diagonally away from the first qubit 831, and the first and second qubits 831, 832 undergo a single-qubit operation over time $\Delta t_{g4} = \Delta t_{g2}$ in the fourth set of locations 804. At the same time as the first group of qubits is shuttled from the third set of locations 803 to the fourth set of locations 804, a second group of qubits comprising a third qubit 833 and a fourth qubit 834 is received at the first set of locations 801.

In this example the shuttling times $\Delta t_{si}$, wherein i denotes the set of locations that the qubit group is transferred from, is equal for each set of locations. Similarly, the operation times $\Delta t_{gi}$, wherein i denotes the set of locations in which the operation is performed, is equal for each set of locations. Typically, the operation time is significantly longer than the shuttling time, $\Delta t_{gi} \gg \Delta t_{si}$. For example, the operation time may be on the order of 1 x $10^{-6}$ s, and the shuttling time may be on the order of 1 x $10^{-9}$ s. In other embodiments, the operation times and/or the shuttling times may differ between sets of locations, and the first and second qubit groups may be separated by more than two unoccupied sets of locations.

A voltage source is used to apply a global offset to specific sets of locations in order to shuttle the groups of qubits along, whilst the underlying electric potential landscape remains fixed. This shuttling process is fast, typically taking around a nanosecond. As such, the third and fourth qubits 833, 834 of the second group of qubits, trapped in the first set of locations 801 in Figure 10C, will undergo the same pattern of interactions as illustrated for the first and second qubits 831, 823 in the first group of qubits in Figures 10A, 10B and 10C.

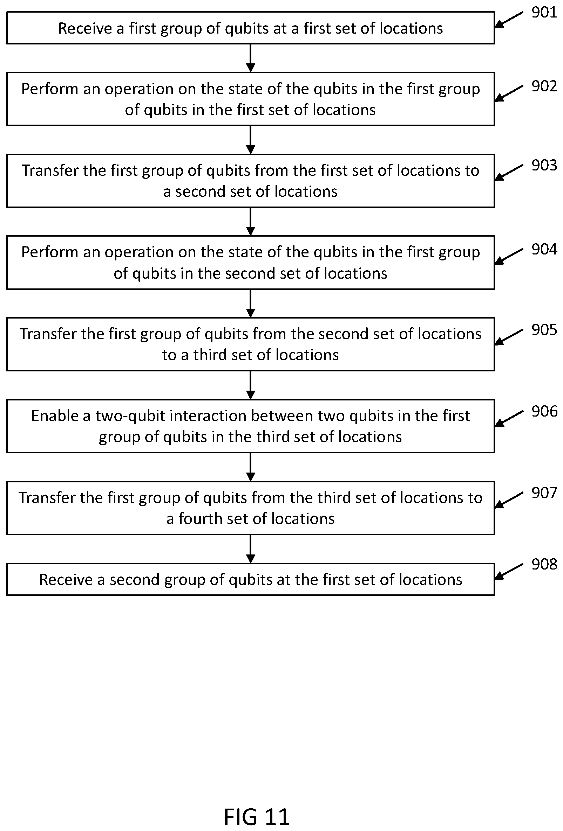

Figure 11 is a flow chart describing an operation involving two qubits in a qubit processing method. A first group of qubits is received 901 at a first set of locations. Following this, the state of the qubits is manipulated 902 in line with pre-determined parameters. The first group of qubits is then transferred 903 from the first set of locations to a second set of locations, at which point the state is once again manipulated 904. After an operation stage in the second set of locations, the first group of qubits is transferred 905 to a third set of locations. In this embodiment, the operations in the first and second sets of locations are single-qubit operations, and there is a two-qubit operation in the third set of locations. The electric potential landscape is such that a two-qubit interaction is enabled 906, typically by bringing two qubits into close proximity to increase the tunnel coupling. For example, a first qubit may move horizontally, and a second qubit may move horizontally and vertically such that it is neighbouring the first qubit. After the two qubit interaction, the first group of qubits is transferred 907 from the third set of locations to a fourth set of locations. Simultaneously, a second group of qubits is received 908 at the first set of locations. The second group of qubits undergoes the same operation, transfer and interaction steps 902-907 as the first group of qubits, with a small time delay. Using this arrangement, multiple groups of qubits can be manipulated and processed in the same way.

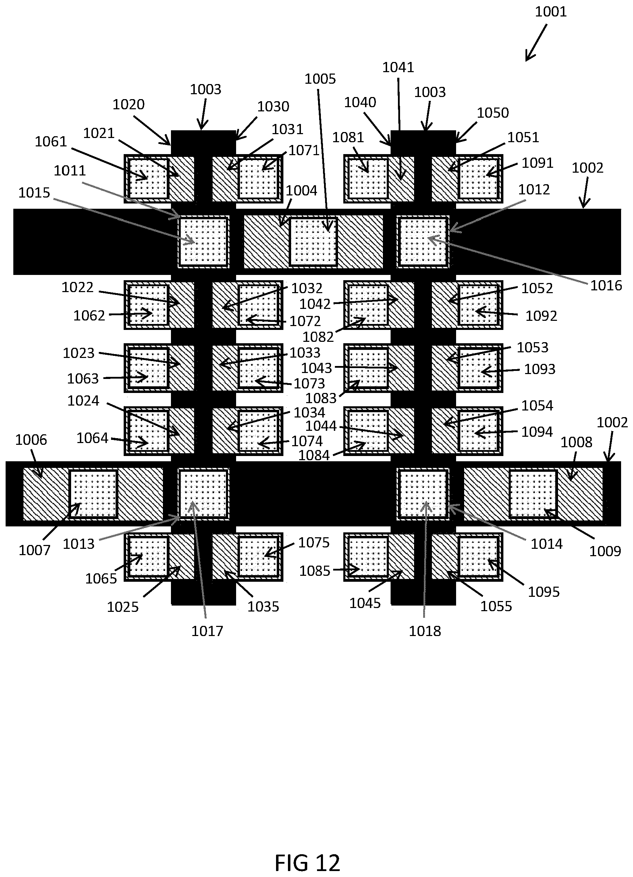

Figure 12 schematically illustrates a top view of an implementation of a qubit processor for electron spin qubits fabricated using SiMOS technology. A silicon-on-insulator (SOI) substrate comprising a lower silicon layer, an intermediate insulating layer and an upper silicon layer is selectively etched such that a raised "grid" 1001 of silicon nanowires (SiNWs) remains. The upper silicon layer is selectively etched to create the grid and is supported by the lower silicon layer and the intermediate insulating layer of the SOI substrate (not shown).

The grid comprises a two dimensional array of orthogonal nanowires, referred to as horizontal SiNWs 1002 and vertical SiNWs 1003. A dielectric material such as silicon dioxide, $SiO_2$, is arranged on top of the SiNWs to form an electrostatic barrier. Four surface electrodes 1011, 1012, 1013, 1014 are provided on a substantially flat region of the grid at the points of intersection between the horizontal and vertical SiNWs 1002, 1003. Three exchange electrodes 1004, 1006, 1008 are provided on a substantially flat region of the horizontal SiNWs 1002. Each exchange region beneath an exchange electrode 1004, 1006, 1008 can be coupled to two confinement regions, wherein a confinement region is beneath a surface electrode 1011-1014. In Figure 12, first and second surface electrodes 1011, 1012 are positioned on opposite sides of the first exchange electrode 1004.

Each of the vertical SiNWs 1003 has two edges 1020, 1030, 1040, 1050. Twenty edge electrodes 1021, 1022, 1023, 1024, 1025, 1031, 1032, 1033, 1034, 1035, 1041, 1042, 1043, 1044, 1045, 1051, 1052, 1053, 1054, 1055 are provided over the edges 1020, 1030, 1040, 1050 of each of the vertical SiNWs 1003. Each edge electrode 1021-1025 on the first edge 1020 is arranged opposite another edge electrode 1031-1035 on the second edge 1030 to form pairs of edge electrodes. Similarly, each edge electrode 1041-1045 on the third edge 1040 is arranged opposite another edge electrode 1051-1055 on the fourth edge 1050 to form pairs of edge electrodes. Each pair of edge electrodes is separated by 10 nanometres. Adjacent pairs of edge electrodes are separated by 10 nanometres. In alternative embodiments, the separation between edge electrodes across the SiNW may be up to 200 nanometres, and the separation between edge electrodes along the SiNW may be up to 200 nanometres. Each edge electrode 1021-1025, 1031-1035, 1041-1045, 1051-1055 is configured such that a quantum dot can be induced in the silicon grid 1001 beneath the respective edge electrode. These quantum dots define locations at which qubits can be received.

The surface electrodes 1011-1014 are formed from polysilicon. A respective conductive via 1015, 1016, 1017, 1018, or vertical interconnect access, formed from gold, is electrically connected to each of the surface electrodes 1011-1014. A bias potential can be applied to the surface electrodes 1011-1014 to induce confinement regions in the silicon grid 1001 beneath the respective surface electrodes 1011-1014. The exchange electrodes 1004, 1006, 1008 also comprise a conductive material and are electrically connected to corresponding conductive vias 1005, 1007, 1009 comprising a conductive material. A bias potential can be applied to the exchange electrodes 1004, 1006, 1008 to dope the region beneath the exchange electrodes to provide a means of exchange of quantum information between the vertical SiNWs 1003.

Similarly, the edge electrodes 1021-1025, 1031-1035, 1041-1045, 1051-1055 comprise a conductive material and are electrically connected to corresponding conductive vias 1061, 1062, 1063, 1064, 1065, 1071, 1072, 1073, 1074, 1075, 1081, 1082, 1083, 1084, 1085, 1091, 1092, 1093, 1094, 1095 which comprise a conductive material. In Figure 12 the conductive vias are positioned at one end of each edge electrode. However, the positioning of the conductive vias does not affect the electrical performance of the device. A bias potential can be applied to the edge electrodes 1021-1025, 1031-1035, 1041-1045, 1051-1055 to induce a quantum dot at the edge of the SiNW.

In alternative embodiments, the exchange electrodes 1004, 1006, 1008, surface electrodes 1011-1014, edge electrodes 1021-1025, 1031-1035, 1041-1045, 1051-1055 and conductive vias 1005, 1007, 1009, 1015-1018, 1061-1065, 1071-1075, 1081-1085, 1091-1095 can be formed from any conductive material.

The edge electrodes 1021-1025, 1031-1035, 1041-1045, 1051-1055 and the surface electrodes 1011-1014 can be used to support a qubit in the silicon grid 1001 during the qubit processing method, and the exchange electrodes 1004, 1006, 1008 can be used to enable a two-qubit interaction.

In the implementation shown in Figure 12, the sets of locations as described in relation to previous figures are parallel to the horizontal SiNWs 1002. Each location in the sets of locations comprises an electrode. The movement of qubits during the qubit processing method is substantially vertical. For example, a first qubit may move (a) from the first edge electrode 1021 of the first edge 1020 to the first surface electrode 1011, then (b) to the second edge electrode 1022 of the first edge 1020, then (c) to the third edge electrode 1023 of the first edge 1020, then (d) to the fourth edge electrode 1034 of the second edge 1030, then (e) to the third surface electrode 1013 and then (f) to the fifth edge electrode 1035 of the second edge 1030. A second qubit may move (a) from the first edge electrode 1051 of the fourth edge 1050 to the second surface electrode 1012, then (b) to the second edge electrode 1052 of the fourth edge 1050, then (c) to the third edge electrode 1053 of the fourth edge 1050, then (d) to the fourth edge electrode 1044 of the third edge 1040, then (e) to the fourth surface electrode 1014 and then (f) to the fifth edge electrode 1045 of the third edge 1040.

The first and second qubits form part of a qubit group which will move through the qubit processor as a group. Steps (a)-(f) for the first qubit occur simultaneously with steps (a)-(f) for the second qubit. In step (a), each of the first qubit and second qubit are transferred from an edge electrode to the first and second surface electrodes 1011, 1012 respectively. At this point, a two-qubit interaction is enabled between the first and second qubits. The two-qubit interaction is mediated by the first exchange electrode 1004. A single-qubit interaction may be performed at any of the pairs of edge electrodes parallel to the horizontal SiNWs 1002. In step (e), the first and second qubits are transferred to third and fourth surface electrodes 1013, 1014 respectively.

In alternative embodiments, there may be any number of edge electrodes positioned between adjacent horizontal SiNWs. Furthermore, there may be exchange electrodes positioned in between each surface electrode. The exchange electrodes can be controlled by selective biasing to control the location of two-qubit gates providing mediated exchange interactions.

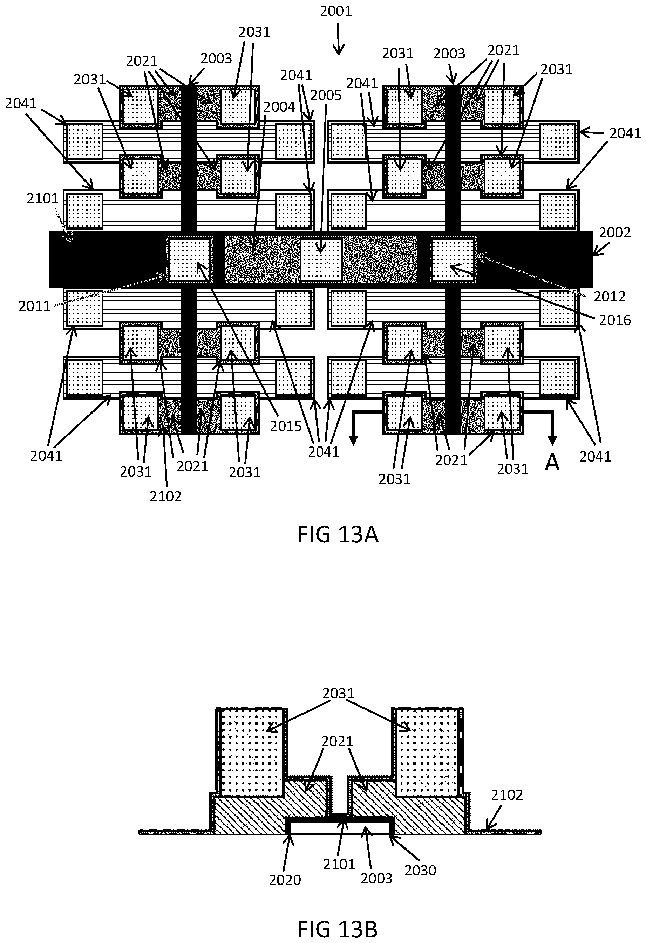

Figures 13A and 13B schematically illustrate a top view and cross-sectional side view respectively of another implementation of a qubit processor. The implementation is similar to that described with reference to Figure 12.

In Figure 13A, a SiNW grid 2001 is provided with a horizontal SiNW 2002 and vertical SiNWs 2003. A first dielectric layer 2101 comprising silicon dioxide, $SiO_2$, is provided on the SiNW grid 2001. An exchange electrode 2004 provided on a substantially planar region of the horizontal SiNW 2002 can be configured to mediate an exchange interaction between the confinement regions beneath first and second surface electrodes 2011, 2012 respectively. The exchange electrode 2004 is electrically connected to a conductive via 2005, and the first and second surface electrodes 2011, 2012 are electrically connected to respective conductive vias 2015, 2016.

Metallic edge electrodes 2021 and conductive vias 2031 are provided along the edges of the vertical SiNWs 2003 as described in relation to Figure 12. A second dielectric layer 2102 is provided on the grid 2001 overlying the SiNWs 2002, 2003, the exchange electrode 2004, the surface electrodes 2011, 2012 and the edge electrodes 2021. Top electrodes 2041 are provided overlying the vertical SiNWs 2003.

The width of the horizontal and vertical SiNWs 2002, 2003 are substantially the same in this embodiment, but this is obscured in the top view as the second dielectric layer 2012 and the top electrodes 2041 are positioned overlying the SiNWs 2002, 2003.

Figure 13B shows a cross-sectional view of the processor along the line A indicated in Figure 13A. The first dielectric layer 2101 is arranged overlying the vertical SiNW 2003. The SiNW 2003 has two edges 2020, 2030. Two metallic edge electrodes 2021 are positioned overlying respective edges 2020, 2030 of the SiNW 2003. Each of the two conductive vias 2031 are in electrical contact with one of the two metallic edge electrodes 2021. A second dielectric layer 2102 is arranged overlying the SiNW 2003 and the metallic edge electrodes 2021.

As will be appreciated, an improved qubit processing method and a qubit processor for use in the NISQ era are provided in which the resources required to perform the method are reduced. Dense qubit architectures can be implemented in SiMOS devices for quantum computing. The simplification of control of large arrays of qubits provided makes the scaling up of these devices feasible.

**Claims**

1. A method for performing quantum computations in a qubit processor, comprising the steps of:

   configuring a first location in a first set of locations to perform a first one-qubit operation;
   configuring a second location in the first set of locations to perform a second one-qubit operation;
   configuring a first location and a second location in a second set of locations to enable a two-qubit interaction;
   receiving a first qubit at the first location in the first set of locations at time $t_1$;
   receiving a second qubit at the second location in the first set of locations at time $t_1$;
   wherein the first qubit and the second qubit are provided within a first qubit group comprising n qubits, wherein n > 2;

   (i) performing the first one-qubit operation on the state of the first qubit at the first location in the first set of locations;
   (ii) performing the second one-qubit operation on the state of the second qubit at the second location in the first set of locations;
   (iii) transferring the first qubit from the first location in the first set of locations to the first location in the second set of locations;
   (iv) transferring the second qubit from the second location in the first set of locations to the second location in the second set of locations;
   (v) enabling the two-qubit interaction between the first qubit and the second qubit in the second set of locations;
   (vi) transferring the first qubit from the first location in the second set of locations to a first location in a readout set of locations;
   (vii) transferring the second qubit from the second location in the second set of locations to a second location in the readout set of locations;
   (viii) reading the state of the first qubit at the first location in the readout set of locations;
   (ix) reading the state of the second qubit at the second location in the readout set of locations;
   (x) receiving a first qubit of a second qubit group at the first location in the first set of locations at time $t_2$, wherein $t_2 > t_1$;
   (xi) receiving a second qubit of the second qubit group at the second location in the first set of locations at time $t_2$; and

   performing steps (i) to (ix) for the first qubit of the second qubit group and the second qubit of the second qubit group.

2. A method according to claim 1, wherein:

the first qubit of the first qubit group is transferred from the first location in the second set of locations to a first location in a third set of locations at time $t_{tr}$; and
the second qubit of the first qubit group is transferred from the second location in the second set of locations to a second location in the third set of locations at time $t_{tr}$; and
wherein $t_2 \geq t_{tr} > t_1$;
wherein the third set of locations is an intermediate set of locations between the second set of locations and the readout set of locations.

3. A method according to claim 1 or claim 2, wherein:

the state of the first qubit of the first qubit group is read at time $t_r$; and
the state of the second qubit of the first qubit group is read at time $t_r$;
wherein $t_r > t_2$.

4. A method according to claim 2 or claim 3, further comprising the steps of:

transferring the first qubit of the first qubit group from the first location in the third set of locations to a first location in a fourth set of locations at time $t_3$;
transferring the second qubit of the first qubit group from the second location in the third set of locations to a second location in the fourth set of locations at time $t_3$;
wherein the fourth set of locations is an intermediate set of locations between the third set of locations and the readout set of locations;
transferring the first qubit of the second qubit group from the first location in the first set of locations to the first location in the second set of locations at time $t_3$; and
transferring the second qubit of the second qubit group from the second location in the first set of locations to the second location in the second set of locations at time $t_3$;
wherein $t_3 > t_2$.

5. A method according to any of the preceding claims, further comprising performing an initialisation operation at the first set of locations.

6. A method according to any of the preceding claims, comprising N sets of locations wherein N > 3 and wherein the readout set of locations is the N-th set of locations.

7. A method according to any of claims 1 to 6, further comprising the step of enabling an interaction between an i-th qubit in the first qubit group and an (i+1)-th qubit in the first qubit group such that each qubit in the first qubit group directly or indirectly interacts with every other qubit in the first qubit group, and wherein $1 \leq i < n$.

8. A method according to any of claims 1 to 7, wherein the first qubit in the first qubit group and the first qubit in the second qubit group do not interact.

9. A method according to any of the preceding claims, wherein each of the transferring steps comprises electron shuttling.

10. A method according to claim 9, wherein the qubits are electron spin qubits or trapped ion qubits.

11. A method according to any of claims 1 to 8, wherein each of the transferring steps comprises a SWAP operation.

**Patentansprüche**

1. Verfahren zum Durchführen von Quantenberechnungen in einem Qubit-Prozessor, das die Schritte umfasst:

Konfigurieren eines ersten Ortes in einem ersten Satz von Orten, um einen ersten Ein-Qubit-Vorgang durchzuführen;
Konfigurieren eines zweiten Ortes in dem ersten Satz von Orten, um einen zweiten Ein-Qubit-Vorgang durchzuführen;
Konfigurieren eines ersten Ortes und eines zweiten Ortes in einem zweiten Satz von Orten, um eine Zwei-Qubit-Interaktion zu ermöglichen;
Empfangen eines ersten Qubits an dem ersten Ort in dem ersten Satz von Orten zu dem Zeitpunkt $t_1$;
Empfangen eines zweiten Qubits an dem zweiten Ort in dem ersten Satz von Orten zu dem Zeitpunkt $t_1$;
wobei das erste Qubit und das zweite Qubit innerhalb eines ersten Qubit-Satzes bereitgestellt werden, das n Qubits umfasst, wobei n > 2 ist;

(i) Durchführen des ersten Ein-Qubit-Vorgangs an dem Zustand des ersten Qubits an dem ersten Ort in dem ersten Satz von Orten;
(ii) Durchführen des zweiten Ein-Qubit-Vorgangs an dem Zustand des zweiten Qubits an dem zweiten Ort in dem ersten Satz von Orten;

(iii) Übertragen des ersten Qubits von dem ersten Ort in dem ersten Satz von Orten zu dem ersten Ort in dem zweiten Satz von Orten;
(iv) Übertragen des zweiten Qubits von dem zweiten Ort in dem ersten Satz von Orten zu dem zweiten Ort in dem zweiten Satz von Orten;
(v) Ermöglichen der Zwei-Qubit-Interaktion zwischen dem ersten Qubit und dem zweiten Qubit in dem zweiten Satz von Orten;
(vi) Übertragen des ersten Qubits von dem ersten Ort in dem zweiten Satz von Orten zu einem ersten Ort in einem Auslesesatz von Orten;
(vii) Übertragen des zweiten Qubits von dem zweiten Ort in dem zweiten Satz von Orten zu einem zweiten Ort in dem Auslesesatz von Orten;
(viii) Lesen des Zustands des ersten Qubits an dem ersten Ort in dem Auslesesatz von Orten;
(ix) Lesen des Zustands des zweiten Qubits an dem zweiten Ort in dem Auslesesatz von Orten;
(x) Empfangen eines ersten Qubits einer zweiten Qubit-Gruppe an dem ersten Ort in dem ersten Satz von Orten zu dem Zeitpunkt $t_2$, wobei $t_2 > t_1$;
(xi) Empfangen eines zweiten Qubits der zweiten Qubit-Gruppe an dem zweiten Ort in dem ersten Satz von Orten zu dem Zeitpunkt $t_2$; und

Durchführen der Schritte (i) bis (ix) für das erste Qubit der zweiten Qubit-Gruppe und des zweiten Qubits der zweiten Qubit-Gruppe.

2. Verfahren nach Anspruch 1, wobei:

das erste Qubit der ersten Qubit-Gruppe von dem ersten Ort in dem zweiten Satz von Orten zu einem ersten Ort in einem dritten Satz von Orten zu dem Zeitpunkt $t_{tr}$ übertragen wird; und
das zweite Qubit der ersten Qubit-Gruppe von dem zweiten Ort in dem zweiten Satz von Orten zu einem zweiten Ort in dem dritten Satz von Orten zu dem Zeitpunkt $t_{tr}$ übertragen wird; und wobei $t_2 \geq t_{tr} > t_1$;
wobei der dritte Satz von Orten ein Zwischensatz von Orten zwischen dem zweiten Satz von Orten und dem Auslesesatz von Orten ist.

3. Verfahren nach Anspruch 1 oder 2, wobei:

der Zustand des ersten Qubits der ersten Qubit-Gruppe zu dem Zeitpunkt $t_r$ gelesen wird; und
der Zustand des zweiten Qubits der ersten Qubit-Gruppe zu dem Zeitpunkt $t_r$ gelesen wird; wobei $t_r > t2$.

4. Verfahren nach Anspruch 2 oder 3, das ferner die Schritte umfasst:

Übertragen des ersten Qubits der ersten Qubit-Gruppe von dem ersten Ort in dem dritten Satz von Orten zu einem ersten Ort in einem vierten Satz von Orten zu dem Zeitpunkt $t_3$;
Übertragen des zweiten Qubits der ersten Qubit-Gruppe von dem zweiten Ort in dem dritten Satz von Orten zu einem zweiten Ort in einem vierten Satz von Orten zu dem Zeitpunkt $t_3$;
wobei der vierte Satz von Orten ein Zwischensatz von Orten zwischen dem dritten Satz von Orten und dem Auslesesatz von Orten ist;
Übertragen des ersten Qubits der zweiten Qubit-Gruppe von dem ersten Ort in dem ersten Satz von Orten zu dem ersten Ort in dem zweiten Satz von Orten zu dem Zeitpunkt $t_3$;
Übertragen des zweiten Qubits der zweiten Qubit-Gruppe von dem zweiten Ort in dem ersten Satz von Orten zu dem zweiten Ort in dem zweiten Satz von Orten zu dem Zeitpunkt $t_3$;
wobei $t_3 > t_2$.

5. Verfahren nach einem der vorhergehenden Ansprüche, das ferner das Durchführen eines Initialisierungsvorgangs an dem ersten Satz von Orten umfasst.

6. Verfahren nach einem der vorhergehenden Ansprüche, umfassend N Sätze von Orten, wobei N > 3 ist und wobei der Auslesesatz von Orten der N-te Satz von Orten ist.

7. Verfahren nach einem der Ansprüche 1 bis 6, das ferner den Schritt des Ermöglichens einer Interaktion zwischen einem i-ten Qubit in der ersten Qubit-Gruppe und einem (i+1)-ten Qubit in der ersten Qubit-Gruppe umfasst, sodass jedes Qubit in der ersten Qubit-Gruppe direkt oder indirekt mit jedem anderen Qubit in der ersten Qubit-Gruppe interagiert, und wobei $1 \leq i < n$.

8. Verfahren nach einem der Ansprüche 1 bis 7, wobei das erste Qubit in der ersten Qubit-Gruppe und das erste Qubit in der zweiten Qubit-Gruppe nicht miteinander interagieren.

9. Verfahren nach einem der vorhergehenden Ansprüche, wobei jeder der übertragenden Schritte ein Elektronen-Shuttling umfasst.

10. Verfahren nach Anspruch 9, wobei die Qubits Elektronenspin-Qubits oder gefangene Ionen-Qubits sind.

**11.** Verfahren nach einem der Ansprüche 1 bis 8, wobei jeder der Übertragungsschritte einen SWAP-Vorgang umfasst.

**Revendications**

**1.** Procédé servant à effectuer des calculs quantiques dans un processeur qubit, comportant les étapes consistant à :

configurer un premier emplacement dans un premier ensemble d'emplacements pour effectuer une première opération à un qubit ;
configurer un deuxième emplacement dans le premier ensemble d'emplacements pour effectuer une deuxième opération à un qubit ;
configurer un premier emplacement et un deuxième emplacement dans un deuxième ensemble d'emplacements pour permettre une interaction à deux qubits ;
recevoir un premier qubit au niveau du premier emplacement dans le premier ensemble d'emplacements à l'instant $t_1$ ;
recevoir un deuxième qubit au niveau du deuxième emplacement dans le premier ensemble d'emplacements à l'instant $t_1$ ;
dans lequel le premier qubit et le deuxième qubit sont fournis à l'intérieur d'un premier groupe de qubits comportant n qubits, dans lequel n > 2 ;

(i) effectuer la première opération à un qubit sur l'état du premier qubit au niveau du premier emplacement dans le premier ensemble d'emplacements ;
(ii) effectuer la deuxième opération à un qubit sur l'état du deuxième qubit au niveau du deuxième emplacement dans le premier ensemble d'emplacements ;
(iii) transférer le premier qubit pour passer du premier emplacement dans le premier ensemble d'emplacements au premier emplacement dans le deuxième ensemble d'emplacements ;
(iv) transférer le deuxième qubit pour passer du deuxième emplacement dans le premier ensemble d'emplacements au deuxième emplacement dans le deuxième ensemble d'emplacements ;
(v) permettre l'interaction à deux qubits entre le premier qubit et le deuxième qubit dans le deuxième ensemble d'emplacements ;
(vi) transférer le premier qubit pour passer du premier emplacement dans le deuxième ensemble d'emplacements à un premier emplacement dans un ensemble d'emplacements de lecture ;

(vii) transférer le deuxième qubit pour passer du deuxième emplacement dans le deuxième ensemble d'emplacements à un deuxième emplacement dans l'ensemble d'emplacements de lecture ;
(viii) lire l'état du premier qubit au niveau du premier emplacement dans l'ensemble d'emplacements de lecture ;
(ix) lire l'état du deuxième qubit au niveau du deuxième emplacement dans l'ensemble d'emplacements de lecture ;
(x) recevoir un premier qubit d'un deuxième groupe de qubits au niveau du premier emplacement dans le premier ensemble d'emplacements à l'instant $t_2$, dans lequel $t_2 > t_1$ ;
(xi) recevoir un deuxième qubit du deuxième groupe de qubits au niveau du deuxième emplacement dans le premier ensemble d'emplacements à l'instant $t_2$ ; et

effectuer les étapes (i) à (ix) pour le premier qubit du deuxième groupe de qubits et le deuxième qubit du deuxième groupe de qubits.

**2.** Procédé selon la revendication 1, dans lequel :

le premier qubit du premier groupe de qubits est transféré du premier emplacement dans le deuxième ensemble d'emplacements à un premier emplacement dans un troisième ensemble d'emplacements à l'instant $t_{tr}$ ; et
le deuxième qubit du premier groupe de qubits est transféré du deuxième emplacement dans le deuxième ensemble d'emplacements à un deuxième emplacement dans le troisième ensemble d'emplacements à l'instant $t_{tr}$ ; et
dans lequel $t_2 \geq t_{tr} > t_1$ ;
dans lequel le troisième ensemble d'emplacements est un ensemble intermédiaire d'emplacements entre le deuxième ensemble d'emplacements et l'ensemble d'emplacements de lecture.

**3.** Procédé selon la revendication 1 ou la revendication 2, dans lequel :

l'état du premier qubit du premier groupe de qubits est lu à l'instant $t_r$ ; et
l'état du deuxième qubit du premier groupe de qubits est lu à l'instant $t_r$ ;
dans lequel $t_r > t_2$.

**4.** Procédé selon la revendication 2 ou la revendication 3, comportant par ailleurs les étapes consistant à :

transférer le premier qubit du premier groupe de qubits pour passer du premier emplacement dans le troisième ensemble d'emplacements à un premier emplacement dans un quatrième ensemble d'emplacements à l'instant $t_3$ ;

transférer le deuxième qubit du premier groupe de qubits pour passer du deuxième emplacement dans le troisième ensemble d'emplacements à un deuxième emplacement dans le quatrième ensemble d'emplacements à l'instant $t_3$ ;

dans lequel le quatrième ensemble d'emplacements est un ensemble intermédiaire d'emplacements entre le troisième ensemble d'emplacements et l'ensemble d'emplacements de lecture ;

transférer le premier qubit du deuxième groupe de qubits pour passer du premier emplacement dans le premier ensemble d'emplacements au premier emplacement dans le deuxième ensemble d'emplacements à l'instant $t_3$ ; et

transférer le deuxième qubit du deuxième groupe de qubits pour passer du deuxième emplacement dans le premier ensemble d'emplacements au deuxième emplacement dans le deuxième ensemble d'emplacements à l'instant $t_3$ ;

dans lequel $t_3 > t_2$.

5. Procédé selon l'une quelconque des revendications précédentes, comportant par ailleurs l'étape consistant à effectuer une opération d'initialisation au niveau du premier ensemble d'emplacements.

6. Procédé selon l'une quelconque des revendications précédentes, comportant N ensembles d'emplacements, dans lequel N > 3 et dans lequel l'ensemble d'emplacements de lecture est le N-ième ensemble d'emplacements.

7. Procédé selon l'une quelconque des revendications 1 à 6, comportant par ailleurs l'étape consistant à permettre une interaction entre un i-ième qubit dans le premier groupe de qubits et un (i+1)-ième qubit dans le premier groupe de qubits de telle sorte que chaque qubit dans le premier groupe de qubits interagit directement ou indirectement avec chaque autre qubit dans le premier groupe de qubits, et dans lequel $1 \leq i < n$.

8. Procédé selon l'une quelconque des revendications 1 à 7, dans lequel le premier qubit dans le premier groupe de qubits et le premier qubit dans le deuxième groupe de qubits n'interagissent pas.

9. Procédé selon l'une quelconque des revendications précédentes, dans lequel chacune des étapes de transfert comporte l'étape consistant à faire déplacer les électrons.

10. Procédé selon la revendication 9, dans lequel les qubits sont des qubits à spin d'électrons ou des qubits à ions piégés.

11. Procédé selon l'une quelconque des revendications 1 à 8, dans lequel chacune des étapes de transfert comporte une opération de PERMUTATION.

FIG 1

FIG 2

FIG 3

FIG 4A

FIG 4B

351 352 353 354

355 →

361 | 371 | 381

356 →

362 | | 382 | 391

357 →

363 | | 383

358 →

364 | 372 | 384 | 392

359 →

365 | | 385

$t_{11}$  $t_{12}$  $t_{13}$  $t_{14}$

FIG 5

FIG 6A

FIG 6B

FIG 6C

FIG 6D

FIG 7

FIG 8A

FIG 8B

Receive a qubit in a location of the n-th set of locations — 701

Perform an operation on the state of the qubit — 702

Transfer the qubit from the location in the n-th set of locations to a location in the (n+1)-th set of locations — 703

FIG 9

854

843
855
831
844
832
856

801 802 803 804

**FIG 10A**

857 831
854
843 845
855 832
846
844 858
856 859

801 802 803 804

**FIG 10B**

833 831
834 832

801 802 803 804

**FIG 10C**

| Receive a first group of qubits at a first set of locations | 901 |

| Perform an operation on the state of the qubits in the first group of qubits in the first set of locations | 902 |

| Transfer the first group of qubits from the first set of locations to a second set of locations | 903 |

| Perform an operation on the state of the qubits in the first group of qubits in the second set of locations | 904 |

| Transfer the first group of qubits from the second set of locations to a third set of locations | 905 |

| Enable a two-qubit interaction between two qubits in the first group of qubits in the third set of locations | 906 |

| Transfer the first group of qubits from the third set of locations to a fourth set of locations | 907 |

| Receive a second group of qubits at the first set of locations | 908 |

FIG 11

FIG 12

FIG 13A

FIG 13B

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2019042965 A1, Clarke J.

**Non-patent literature cited in the description**

- **LI R.** *A Crossbar Network for Silicon Quantum Dot Qubits*, 10 November 2017